# EUROPÄISCHE PATENTSCHRIFT

(11) **EP 4 135 490 B1**
(45) Veröffentlichungstag und Bekanntmachung des Hinweises auf die Patenterteilung: **22.04.2026**
(21) Anmeldenummer: 22187216.1
(22) Anmeldetag: 27.07.2022
(51) Int. Cl.: H05K 5/00, H05K 7/14

(54) **MODULAR AUFGEBAUTES SCHNITTSTELLENKONZEPT FÜR EINEN ELEKTRISCHEN ANTRIEB**
MODULAR INTERFACE CONCEPT FOR AN ELECTRIC DRIVE
CONCEPT MODULAIRE D'INTERFACE POUR UN ENTRAÎNEMENT ÉLECTRIQUE

(30) Priorität: 09.08.2021 DE 102021120679
(43) Veröffentlichungstag der Anmeldung: 15.02.2023
(73) Patentinhaber: ebm-papst Mulfingen GmbH & Co. KG, 74673 Mulfingen (DE)
(72) Erfinder: Bürkert, Martin, 74677 Dörzbach-Hohebach (DE); Haas, Günter, 74673 Mulfingen (DE); Rupp, Thomas, 97959 Assamstadt (DE); König, Daniel, 74582 Gerabronn (DE); Bader, Andreas, 74542 Braunsbach (DE)
(74) Vertreter: Staeger & Sperling Partnerschaftsgesellschaft mbB

(56) Entgegenhaltungen:
- EP-A1- 3 166 214
- US-A1- 2009 079 281
- US-A1- 2017 354 047

## Beschreibung

Die Erfindung betrifft ein modular aufgebautes Schnittstellenkonzept für einen elektrischen Antrieb, insbesondere für einen Elektromotor.

Die elektrische Antriebstechnik ist heute in diversen Bereichen, wie Haushalt, Gewerbe und vor allem in den vielen Bereichen industrieller Produktion präsent. Besonders hier steigt ihre Bedeutung mit dem fortschreitenden Grad der Automation einer Fertigung. Kernstück des elektrischen Industrieantriebs ist einerseits der Elektromotor als Energiewandler zwischen dem elektrischen Netz und der Arbeitsmaschine, die mechanische Energie benötigt und andererseits die Motorsteuerung. Die Leistungselektronik ist dabei eine der drei zentralen Komponenten jedes elektrischen Antriebes. Ihre Aufgabe ist die Ansteuerung der elektrischen Maschine, die Kommunikation mit der Steuerung sowie die Diagnose des Antriebs.

Unter dem Begriff "Leistungselektronik" versteht man alles, was mit Steuerung, Umformung oder dem Schalten von elektrischer Energie mit elektronischen Bauelementen zu tun hat. Dies beginnt bereits bei wenigen 100mA und wenigen Volt, reicht aber bis zu mehreren 100kV und mehreren 1000A. Bei kleineren Spannungen und Strömen besteht die Herausforderung nicht in den absoluten Werten selbst, sondern in der Umformung mit einem besonders hohen Wirkungsgrad und mit möglichst geringen EMV-Abstrahlungen.

Leistungselektronik bzw. leistungselektronische Systeme bestehen immer zumindest aus einem Steuerungs- bzw. Regelteil, und dem Leistungsteil selbst und ggf. Schnittstellen zur Verbindung und Kommunikation mit weiteren elektronischen Komponenten. Ein solches Leistungsteil - oft auch unmittelbar als "Leistungselektronik" bezeichnet - besteht selbst wieder aus mehreren Komponenten, die immer aufeinander und die Anwendung abgestimmt sein müssen.

Aufgrund der Vielfalt der Anwendungen und der jeweils spezifischen Anforderungen sind die benötigten Schnittstellen für einen bestimmten Elektromotor oder einen bestimmten elektrischen Antrieb auf einer einzigen Leistungselektronik implementiert. Das bedeutet, dass die Leistungselektronik alle erforderlichen Schnittstellen in den bekannten Anwendungen integral aufweist. Insofern gibt es auch eine hohe Varianz an Leistungselektroniken, selbst in der gleichen Leistungsklasse.

Es ist jedoch wünschenswert neben der Reduktion der Anzahl der Varianten, dennoch die vollständige Funktionalität für die Anwendung zu erhalten und insbesondere auch eine Flexibilität in der Auslegung der Leistungselektronik für eine Vielzahl an Motoren und Leitungsklassen zu erzielen.

Druckschriftlicher Stand der Technik im vorliegenden Technischen Gebiet ist in den Dokumenten US 2009/079 281 A1, EP 3 166 214 A1 und US 2017/354 047 A1 offenbart.

Der Erfindung liegt daher die Aufgabe zugrunde, vorbesagte Nachteile im Stand der Technik zu überwinden und ein verbessertes, kostengünstig herstellbares Konzept für Motorsteuerungen und deren Leistungselektronik bereit zu stellen.

Diese Aufgabe wird durch die Merkmalskombination gemäß Patentanspruch 1 gelöst.

Erfindungsgemäß ist eine modular aufgebaute Steuereinheit vorgesehen, die spezifisch betreffend Schnittstellenfunktionen anpassbar ist und zwar für einen Elektromotor ausgewählt aus einer vorbestimmten Menge i an Elektromotoren, insbesondere an Elektromotoren der gleichen Leistungsklasse (insbesondere Baugrößen und Leistungsübergreifend), wobei die Steuereinheit zumindest zwei Leiterplatten besitzt, ausgewählt aus einem Set aus N unterschiedlichen Leiterplatten L1, L2, ..., LN auf denen sich Schnittstellenfunktionen, elektrische Bauelemente, elektronische Komponenten oder Steuereinheiten für den Betrieb des Elektromotors befinden, wobei eine Leiterplatte als Basisleiterplatte mit einer Leistungselektronik für die Elektromotoren ausgestattet ist und in einem ersten Gehäuse der Steuereinheit untergebracht ist und wobei weitere Schnittstellenfunktionen der Leistungselektronik auf der weiteren Leiterplatten getrennt von der Leistungselektronik vorgesehen sind und diese zweite Leiterplatte in einem vom ersten Gehäuse getrennten zweiten Gehäuse vorgesehen ist und wobei das erste Gehäuse eine die erste Leiterplatte umschließende Gehäusewandung besitzt, an dem das zweite Gehäuse außerhalb des ersten Gehäuses montiert ist.

Weiter vorteilhaft ist es, wenn das zweite Gehäuse ein Klemmkasten ist und die zweite Leiterplatte von dessen umfangsgeschlossener Wandung umgeben ist. Somit kann die Ergänzungsleiterplatte getrennt in einem Klemmkasten untergebracht sein.

Ebenfalls vorteilhaft ist eine Ausgestaltung bei der das zweite Gehäuse auf einem Gehäuseabschnitt an einer außenliegenden und gestuften Freisparung des ersten Gehäuses auflagert oder aufsattelt und dadurch die Form des ersten Gehäuses ergänzt wird, insbesondere in der Gestalt, dass die Form der beiden Gehäuse jeweils als ein Teilsegment eines im wesentlichen zylinderförmigen Körpers gebildet sind und im zusammen montierten Zustand sich im Wesentlichen zu einem gemeinsamen Zylinderkörper ergänzen bzw. eine entsprechende zylinderförmige Hüllkurve gemeinsam definieren.

In einer weiteren bevorzugten Ausführungsform der Erfindung weist das zweite Gehäuse Kabeleinführungen mit Kabelverschraubungen integral auf, um daran die elektrischen Verbindungsanschlüsse vorzunehmen.

Ebenfalls vorteilhaft ist die modularte Trennung der sich ergänzenden Gehäusen, da beide Gehäuse dann jeweils eine eigene Dichtebene bzw. Dichtungsfunktion getrennt voneinander besitzen.

Wie bereits zuvor erläutert kann man aus einem Set an Leiterplatten jeweils für einen bestimmten Elektromotor eine Steuerung modular zusammenstellen und gleichzeitig auf einfache und kostengünstige Weise, Dichtungsfunktion, Montage und elektrische Funktionen geschickt kombinieren. Hierzu wird ein Set an Leiterplatten vorgesehen, auf denen sich besagte Schnittstellenfunktionen, elektrische Bauelemente, elektronische Komponenten oder Steuereinheiten für den Betrieb eines Elektromotors befinden, insbesondere wenigstens eine der Leiterplatten mit einer Leistungselektronik für die Elektromotoren ausgestattet ist und wobei einige oder mehrere der Schnittstellenfunktionen, insbesondere derjenigen originären Schnittstellenfunktionen der Leistungselektronik auf einer oder mehrerer der weiteren Leiterplatten getrennt von der Leistungselektronik vorgesehen sind bzw. befinden.

Die Anzahl N der Leiterplatten und die Anzahl i der Elektromotoren, sowie weitere genannte Mengen oder Teilmengen verstehen sich selbstverständlich als ganzzahlig, somit als eine positive Zahl ausgewählt aus der Gruppe der natürlichen Zahlen.

Das Leistungsteil weist zur Abgrenzung zu den weiteren Ergänzungsleiterplatten die folgenden wesentlichen Bauteile auf:
1. Leistungshalbleiter (z. B. FET, Mosfet-Übersicht, IGBT, TRIAC)
2. Zwischenkreiskapazität
3. Niederinduktiver Aufbau zwischen Zwischenkreiskondensator und Leistungshalbleiter
4. Ansteuerschaltung = Treiber
5. Spannungsversorgung für den Treiber
6. Überwachungs- und Abschaltvorrichtung

Diese Bauteile können auch in Baugruppen vereint sein.

Die Lösung gemäß der vorliegenden Erfindung stellt eine besonders pfiffige Separation der Funktionseinheiten einer Motorsteuerung dar, wodurch die Varianz der Anzahl an Motorsteuerungen deutlich reduziert werden kann, ohne, dass jedoch Basisfunktionen fehlen. Andererseits lassen sich durch die Separation bestimmter Schnittstellenfunktionen der Leistungselektronik auf eine oder mehrere andere (davon separierte und eigenständige) Leiterplatten durch geschickte Kombination somit Basislösungen, verbesserte Lösungen und Premiumlösungen für den Anwender realisieren, ohne dass aber die Leistungselektronik jeweils modifiziert werden müsste.

In einer weiteren bevorzugten Ausgestaltung der Erfindung ist vorgesehen, dass zwei oder mehrere Leiterplatten sich in ihrer Topologie nur durch jeweils weitere implementierte Funktionsbaugruppen und/oder weitere Bauelemente unterscheiden. Dieser spezifische modulare Aufbau stellt sozusagen auf die Realisierung der zuvor genannten Stufen ab, so dass sich immer eine Basislösung und ergänzend verschiedene verbesserte Lösungen und Premiumlösungen für den Anwender mit einer einzigen Leistungselektronik realisieren lassen.

Weiter vorteilhaft ist es, wenn mehrere Schnittstellenfunktionen zu Schnittstellenfunktionsgruppen zusammengefasst sind und als solche Schnittstellenfunktionsgruppen auf wenigstens zwei oder mehreren der Leiterplatten integriert sind.

Besonders vorteilhaft ist eine Ausgestaltung bei der wenigstens eine der Leiterplatten (Basis-Leiterplatte), die zur Steuerung des ausgewählten Motors erforderlichen Basisfunktionsbauteile aufweisen.

Weiter vorteilhaft ist es, wenn wenigstens eine der weiteren Leiterplatten (Ergänzungsleiterplatte), die mit weiteren Funktionsbauteilen zur Ergänzung der Funktion derjenigen Leiterplatte mit den Basisfunktionsbauteilen ausgebildet ist.

In einer weiteren bevorzugten Ausführungsform der Erfindung ist vorgesehen, dass diejenige Leiterplatte mit den Basisfunktionen zum Betrieb des Elektromotors wenigstens eine Schnittstelle aufweist, für kundenspezifische Funktionen.

Ebenfalls von Vorteil ist es, wenn es eine Schnittstelle auf der Basisleiterplatte zur Verbindung mit der Ergänzungsleiterplatte gibt und insbesondere eine Schnittstelle zur Spannungsversorgung der jeweiligen Ergänzungsleiterplatte.

Ein weiterer Aspekt der vorliegenden Erfindung betrifft neben dem Set auch ein Verfahren zum Zusammenstellen einer Motorsteuerung für einen Motor einer bestimmten Leistungsklasse aus dem genannten Set an Leiterplatten, wobei abhängig von den zu realisierenden Funktionen wenigstens die Leiterplatte mit der Leistungselektronik und wenigstens eine oder mehrere der weiteren Leiterplatte aus dem Set ausgewählt werden und diese miteinander elektrisch über ihre Schnittstellen verbunden werden, wobei wenigstens eine Leiterplatte gezielt ausgewählt wurde, auf der Schnittstellenfunktionen der Leistungselektronik getrennt von der Leiterplatte mit der Leistungselektronik angeordnet sind.

Ein ebenfalls weiterer Aspekt der vorliegenden Erfindung betrifft neben dem Set der Leiterplatten auch einen Elektromotor mit einer Motorsteuerung zusammengestellt aus wenigstens einer ersten Leiterplatte mit einer Leistungselektronik und einer weiteren Leiterplatte, jeweils ausgewählt aus dem Set der Leiterplatten.

Grundsätzlich sind alle offenbarten Merkmale beliebig kombinierbar, soweit dies technisch möglich und sinnvoll ist.

Andere vorteilhafte Weiterbildungen der Erfindung sind in den Unteransprüchen gekennzeichnet bzw. werden nachstehend zusammen mit der Beschreibung der bevorzugten Ausführung der Erfindung anhand der Figuren näher dargestellt.

Es zeigen:
- Fig. 1: zwei beispielhafte Darstellungen jeweils einer modular aufgebauten Steuereinheit;
- Fig. 2: eine Darstellung der separierten Steuereinheit in ihre Einzelbaugruppen und
- Fig. 3: eine beispielhafte Zusammenstellung von einer Basisleiterplatte und einer Ergänzungsleiterplatte.

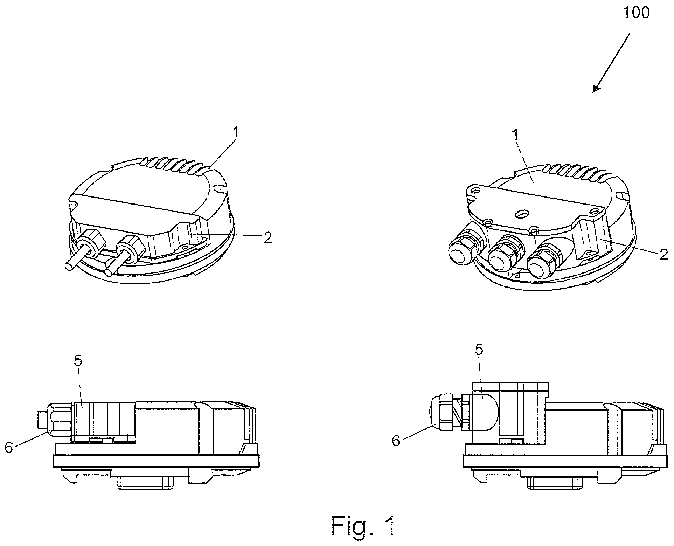

Im Folgenden wird die Erfindung anhand eines lediglich beispielhaften Ausführungsbeispiels mit Bezug auf die Figuren 1 bis 3 näher erläutert, wobei gleiche Bezugszeichen in der Figur strukturell und/oder funktional gleiche oder gleichartige Teile benennen.

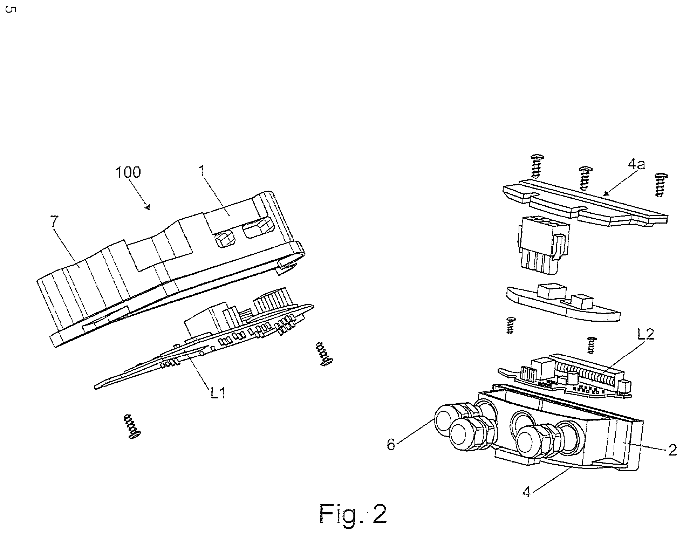

In den Figuren 1 und 2 sind zwei beispielhafte Darstellungen jeweils einer modular aufgebauten Steuereinheit 100.

Die modular aufgebaute Steuereinheit 100 besitzt jeweils ein erstes Basisgehäuse 1 und ein davon getrenntes Gehäuse 2. In dem ersten Gehäuse 1 der Steuereinheit 100 ist die Leistungselektronik LE untergebracht, während im Klemmkasten 2 die weitere Leiterplatten L2 getrennt von der Leistungselektronik LE vorgesehen ist. Der Klemmkasten 2 sitzt auf der die erste Leiterplatte 1 umschließenden Gehäusewandung 3 und ist so an dem Gehäuse 1 und zwar außerhalb des ersten Gehäuses 1 montiert.

Die zweite Leiterplatte L2 ist im Klemmkasten von dessen umfangsgeschlossener Wandung 4 umgeben, wobei ein lösbarer Deckel 4a ein Teil der Wandung 4 bildet ist. Das Basisgehäuse 1 hat einen topfartigen Deckel 7 und eine Bodenplatte 8. Das zweite Gehäuse 2 liegt auf einem Gehäuseabschnitt an einer außenliegenden und gestuften Freisparung des ersten Gehäuses 1 auf und ergänzt dadurch die Form des ersten Gehäuses 1.

Der Klemmkasten 2 besitz die Kabeleinführungen 5 mit Kabelverschraubungen 6.

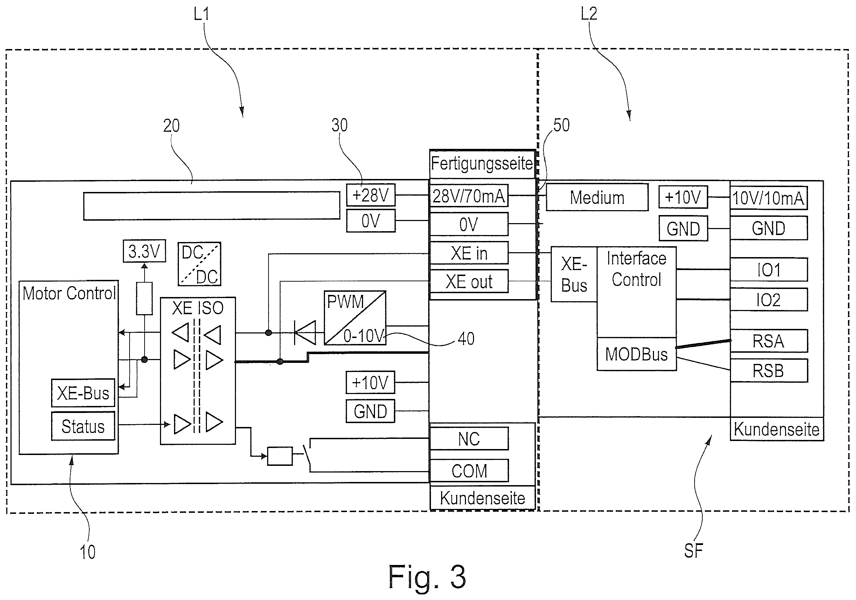

In der Figur 3 ist ein erstes lediglich beispielhaftes funktionales Ausführungsbeispiel gezeigt und zwar ein Set aus zwei Leiterplatten, nämlich eine erste Leiterplatte L1 und einer Ergänzungsleiterplatte L2 jeweils mit Schnittstellenfunktionen SF.

Auf der Leiterplatte L1 befinden sich neben der Motorsteuerung 10, ein DC/DC-Wandler 20, eine Spannungsversorgung 30, ein PWM-Modul 40, sowie diverse weitere nicht näher genannte Schnittstellen und Schnittstellenfunktionen SF, sowie Schnittstellenfunktionen der Kundenschnittstelle.

Auf der Leiterplatte L2 befinden sich MOD-Bus, Controller und Anschlüsse 50 zur Spannungsversorgung ausgehend von der ersten Leiterplatte L1, sowie weitere Schnittstellenfunktionen SF.

Somit zeigt die Figur 1 ein Teil eines Sets aus zumindest zwei Leiterplatten L1, L2 auf denen sich Schnittstellenfunktionen, elektrische Bauelemente, elektronische Komponenten oder Steuereinheiten für den Betrieb eines Elektromotors befinden, ausgewählt aus einer vorbestimmten Menge an Elektromotoren, insbesondere an Elektromotoren der gleichen Leistungsklasse. Diese Kombination aus den beiden ausgewählten Leiterplatten stellt dabei z. B eine Basis-Steuerungen mit unterschiedlichen Funktionen zum Steuern des jeweiligen Elektromotors dar, wobei zum Beispiel die Leiterplatte L2 durch eine erweiterte andere Leiterplatte ersetzt werden kann, um für den gleichen Motor oder einen Motor gleicher Leistungsklasse weitere Funktionen bereit zu stellen. Dabei ist die Leiterplatten L1 mit einer Leistungselektronik LE für die damit ausstattbaren Elektromotoren versehen, wobei einige der Schnittstellenfunktionen der Leistungselektronik LE allerdings auf der zweiten Leiterplatte L2 getrennt von der Leistungselektronik LE installiert sind.

## Patentansprüche

1. Modular aufgebaute Steuereinheit (100), die spezifisch betreffend Schnittstellenfunktionen anpassbar ist für einen Elektromotor ausgewählt aus einer vorbestimmten Menge i an Elektromotoren, insbesondere an Elektromotoren der gleichen Leistungsklasse, wobei die Steuereinheit (100) zumindest zwei Leiterplatten (L1, L2) besitzt, ausgewählt aus einem Set aus N unterschiedlichen Leiterplatten (L1, L2, ..., LN) auf denen sich Schnittstellenfunktionen, elektrische Bauelemente, elektronische Komponenten oder Steuereinheiten für den Betrieb des Elektromotors befinden, wobei eine Leiterplatte (L1) als Basisleiterplatte mit einer Leistungselektronik (LE) für die Elektromotoren ausgestattet ist und in einem ersten Gehäuse (1) der Steuereinheit (100) untergebracht ist und wobei weitere Schnittstellenfunktionen der Leistungselektronik (LE) auf der weiteren Leiterplatte (L2) getrennt von der Leistungselektronik (LE) vorgesehen sind und diese zweite Leiterplatte (L2) in einem vom ersten Gehäuse (1) getrennten Gehäuse (2) vorgesehen ist und wobei das erste Gehäuse (1) eine die erste Leiterplatte (1) umschließende Gehäusewandung (3) besitzt, an dem das zweite Gehäuse (2) außerhalb des ersten Gehäuses (1) montiert ist.

2. Modular aufgebaute Steuereinheit (100) gemäß Anspruch 1, **dadurch gekennzeichnet, dass** das zweite Gehäuse (2) ein Klemmkasten ist und die zweite Leiterplatte (L2) von dessen umfangsgeschlossener Wandung (4) umgeben ist.

3. Modular aufgebaute Steuereinheit (100) gemäß Anspruch 1 oder 2, **dadurch gekennzeichnet, dass** das zweite Gehäuse (2) auf einem Gehäuseabschnitt an einer außenliegenden und gestuften Freisparung des ersten Gehäuses auflagert und dadurch die Form des ersten Gehäuses ergänzt.

4. Modular aufgebaute Steuereinheit (100) gemäß einem der vorhergehenden Ansprüche, **dadurch gekennzeichnet, dass** das zweite Gehäuse (2) Kabeleinführungen (5) mit Kabelverschraubungen (6) integral aufweist und/oder dass das zweite Gehäuse (2) einen Steckanschluss / Steckverbinder integral aufweist.

5. Modular aufgebaute Steuereinheit (100) gemäß einem der vorhergehenden Ansprüche, **dadurch gekennzeichnet, dass** beide Gehäuse (1, 2) als getrennt voneinander gebildete eigenständige Gehäuse ausgebildet sind, die jeweils eine eigene Dichtebene besitzen.

6. Modular aufgebaute Steuereinheit (100) gemäß einem der vorhergehenden Ansprüche, **dadurch gekennzeichnet, dass** die Form der beiden Gehäuse (1, 2) jeweils als ein Teilsegment eines im wesentlichen zylinderförmigen Körpers gebildet sind und im montierten Zustand sich im Wesentlichen zu einem Zylinderkörper ergänzen.

7. Modular aufgebaute Steuereinheit (100) gemäß einem der vorhergehenden Ansprüche, **dadurch gekennzeichnet, dass** mehrere Schnittstellenfunktionen zu Schnittstellenfunktionsgruppen zusammengefasst sind und als solche Schnittstellenfunktionsgruppen auf wenigstens zwei oder mehreren der Leiterplatten (L1, L2, ..., LN) integriert sind.

8. Modular aufgebaute Steuereinheit (100) gemäß einem der vorhergehenden Ansprüche, **dadurch gekennzeichnet, dass** wenigstens eine der Leiterplatten (L2, L3, ..., LN) (Ergänzungsleiterplatte) mit weiteren Funktionsbauteilen zur Ergänzung der Funktion derjenigen Leiterplatte mit den Basisfunktionsbauteilen ausgebildet ist.

9. Modular aufgebaute Steuereinheit (100) gemäß einem der vorhergehenden Ansprüche, **dadurch gekennzeichnet, dass** diejenige Leiterplatte mit den Basisfunktionen zum Betrieb des Elektromotors wenigstens eine Schnittstelle, für kundenspezifische Funktionen aufweist.

10. Modular aufgebaute Steuereinheit (100) gemäß einem der vorhergehenden Ansprüche, **dadurch gekennzeichnet, dass** es eine Schnittstelle auf der Basisleiterplatte (L1) zur Verbindung mit der Ergänzungsleiterplatte (L2, L3, ..., LN) gibt und insbesondere eine Schnittstelle zur Spannungsversorgung der Ergänzungsleiterplatte (L2, L3, ..., LN).

11. Verfahren zum Zusammenstellen einer Steuereinheit (100) gemäß einem der vorhergehenden Ansprüche für einen Motor einer bestimmten Leistungsklasse, wobei abhängig von den zu realisierenden Funktionen wenigstens die Basis-Leiterplatte (L1) mit der Leistungselektronik und wenigstens eine oder mehrere der weiteren Leiterplatte (L2, L3,...., LN) ausgewählt werden und diese miteinander elektrisch über ihre Schnittstellen verbunden werden, wobei wenigstens eine Leiterplatte (L2, L3,...., LN) ausgewählt wurde, auf der Schnittstellenfunktionen der Leistungselektronik getrennt von der Leiterplatte (L1) mit der Leistungselektronik angeordnet sind und diese Leiterplatte vorzugsweise in einem Klemmkasten der Steuereinheit (100) installiert wird.

## Claims

1. Modular control unit (100), which is specifically adaptable in terms of interface functions for an electric motor selected from a predetermined set of electric motors, in particular of electric motors of the same power class, wherein the control unit (100) has at least two printed circuit boards (L1, L2), selected from a set of N different printed circuit boards (L1, L2, ..., LN) on which interface functions, electrical components, electronic components or control units for the operation of the electric motor are located, wherein a printed circuit board (L1) as a basic printed circuit board is equipped with power electronics (LE) for the electric motors and is accommodated in a first housing (1) of the control unit (100) and wherein further interface functions of the power electronics (LE) are provided separately from the power electronics (LE) on the other printed circuit board (L2) and this second printed circuit board (L2) is provided in a housing (2) separate from the first housing (1) and wherein the first housing (1) has a housing wall (3) enclosing the first circuit board (1), on which the second housing (2) is mounted outside the first housing (1).

2. Modular control unit (100) of claim 1, **characterized in that** the second housing (2) is a terminal box and the second printed circuit board (L2) is surrounded by its peripherally closed wall (4).

3. Modular control unit (100) of claim 1 or 2, **characterized in that** the second housing (2) rests on a housing portion at an external and stepped recess of the first housing and thereby complements the shape of the first housing.

4. Modular control unit (100) of any one of preceding claims, **characterized in that** the second housing (2) has integral cable entries (5) with cable glands (6) and/or that the second housing (2) has an integral plug-in connection/connector.

5. Modular control unit (100) of any one of the preceding claims, **characterized in that** both housings (1, 2) are designed as standalone housings formed separately from each other, each having its own sealing level.

6. Modular control unit (100) of any one of the preceding claims, **characterized in that** the shape of both housings (1, 2) is formed in each case as a sub-segment of a substantially cylindrical body and complement each other to essentially form a cylinder body in the assembled state.

7. Modular control unit (100) of any one of the preceding claims, **characterized in that** a plurality of interface functions are combined into interface function groups and such interface functional groups are integrated on at least two or more of the printed circuit boards (L1, L2, ..., LN).

8. Modular control unit (100) of any one of the preceding claims, **characterized in that** at least one of the printed circuit boards (L2, L3, ..., LN) (supplementary printed circuit board) is provided with further functional components to supplement the function of said printed circuit board having the basic functional components.

9. Modular control unit (100) of any one of the preceding claims, **characterized in that** said printed circuit board having the basic functions for operating the electric motor has at least one interface for customer-specific functions.

10. Modular control unit (100) of any one of the preceding claims, **characterized in that** there is an interface on the basic printed circuit board (L1) for connection to the supplementary printed circuit board (L2, L3, ..., LN) and in particular an interface for the power supply of the supplementary printed circuit board (L2, L3,..., LN).

11. Method for assembling a control unit (100) of any one of the preceding claims for a motor of a specific power class, wherein, depending on the functions to be implemented, at least the basic printed circuit board (L1) having the power electronics
and at least one or more of the further printed circuit boards (L2, L3,...., LN) are selected and these are electrically connected to one another via their interfaces, with at least one printed circuit board (L2, L3,...., LN) being selected, on which interface functions of the power electronics are arranged separate from the printed circuit board (L1) with the power electronics and this printed circuit board is preferably installed in a terminal box of the control unit (100).

## Revendications

1. Unité de commande (100) à structure modulaire, qui est adaptable spécifiquement en ce qui concerne des fonctions d'interface pour un moteur électrique choisi parmi un ensemble prédéterminé i de moteurs électriques, en particulier de moteurs électriques de la même classe de puissance, l'unité de commande (100) possédant au moins deux cartes de circuits imprimés (L1, L2) choisies parmi un ensemble de N cartes de circuits imprimés différentes (L1, L2,..., LN) sur lesquelles se trouvent des fonctions d'interface, des composants électriques, des composants électroniques ou des unités de commande pour le fonctionnement du moteur électrique, une carte de circuit imprimé (L1) étant équipée, en tant que carte de circuit imprimé de base, d'une électronique de puissance (LE) pour les moteurs électriques et étant logée dans un premier boîtier (1) de l'unité de commande (100), et d'autres fonctions d'interface de l'électronique de puissance (LE) étant prévues sur l'autre carte de circuit imprimé (L2) séparément de l'électronique de puissance (LE), et cette deuxième carte de circuit imprimé (L2) étant prévue dans un boîtier (2) séparé du premier boîtier (1), et le premier boîtier (1) possédant une paroi de boîtier (3) entourant la première carte de circuit imprimé (1), sur laquelle le deuxième boîtier (2) est monté à l'extérieur du premier boîtier (1).

2. Unité de commande (100) à structure modulaire selon la revendication 1, **caractérisée en ce que** le deuxième boîtier (2) est une boîte à bornes et la deuxième carte de circuit imprimé (L2) est entourée par sa paroi (4) fermée sur la périphérie.

3. Unité de commande (100) à structure modulaire selon la revendication 1 ou 2, **caractérisée en ce que** le deuxième boîtier (2) prend appui sur une section de boîtier au niveau d'un évidement étagé situé à l'extérieur du premier boîtier et complète ainsi la forme du premier boîtier.

4. Unité de commande (100) à structure modulaire selon l'une des revendications précédentes, **caractérisée en ce que** le deuxième boîtier (2) présente de manière intégrale des entrées de câbles (5) avec des presse-étoupes (6) et/ou **en ce que** le deuxième boîtier (2) présente de manière intégrale un raccord à fiche / connecteur enfichable.

5. Unité de commande (100) à structure modulaire selon l'une des revendications précédentes, **caractérisée en ce que** les deux boîtiers (1, 2)sont réalisés sous la forme de boîtiers autonomes formés séparément l'un de l'autre, qui possèdent chacun leur propre plan d'étanchéité.

6. Unité de commande (100) à structure modulaire selon l'une des revendications précédentes, **caractérisée en ce que** la forme des deux boîtiers (1, 2) est formée respectivement comme un segment partiel d'un corps sensiblement cylindrique et, à l'état monté, se complète pour former sensiblement un corps cylindrique.

7. Unité de commande (100) à structure modulaire selon l'une des revendications précédentes, **caractérisée en ce que** plusieurs fonctions d'interface sont regroupées en groupes de fonctions d'interface et sont intégrées en tant que tels groupes de fonctions d'interface sur au moins deux ou plusieurs des cartes de circuits imprimés (L1, L2,..., LN).

8. Unité de commande (100) à structure modulaire selon l'une des revendications précédentes, **caractérisée en ce qu'**au moins l'une des cartes de circuits imprimés (L2, L3,..., LN) (carte de circuit imprimé complémentaire) est réalisée avec d'autres composants fonctionnels pour compléter la fonction de la carte de circuit imprimé présentant les composants fonctionnels de base.

9. Unité de commande (100) à structure modulaire selon l'une des revendications précédentes, **caractérisée en ce que** la carte de circuit imprimé présentant les fonctions de base pour le fonctionnement du moteur électrique présente au moins une interface, pour des fonctions spécifiques au client.

10. Unité de commande (100) à structure modulaire selon l'une des revendications précédentes, **caractérisée en ce qu'**il existe une interface sur la carte de circuit imprimé de base (L1) pour la liaison avec la carte de circuit imprimé complémentaire (L2, L3,..., LN) et en particulier une interface pour l'alimentation électrique de la carte de circuit imprimé complémentaire (L2, L3,..., LN).

11. Procédé pour l'assemblage d'une unité de commande (100) selon l'une des revendications précédentes pour un moteur d'une certaine classe de puissance, dans lequel, en fonction des fonctions à réaliser, au moins la carte de circuit imprimé de base (L1) avec l'électronique de puissance et au moins l'une ou plusieurs des autres cartes de circuits imprimés (L2, L3,...., LN) sont choisies et celles-ci sont reliées entre elles électriquement par l'intermédiaire de leurs interfaces, au moins une carte de circuit imprimé (L2, L3,...., LN) ayant été choisie, sur laquelle des fonctions d'interface de l'électronique de puissance sont disposées séparément de la carte de circuit imprimé (L1) avec l'électronique de puissance, et cette carte de circuit imprimé est de préférence installée dans une boîte à bornes de l'unité de commande (100).
